# EUROPEAN PATENT APPLICATION

(11) **EP 2 778 589 A2**
(43) Date of publication of application: **17.09.2014**
(21) Application number: 13199193.7
(22) Date of filing: 20.12.2013
(51) Int. Cl.: F28D 1/053

(54) **Thermoelectric power generation condenser**

(30) Priority: 12.03.2013 US 201313795412
(71) Applicant: Hussmann Corporation, Bridgeton MO 63044-2483 (US)
(72) Inventor: Twohy, Raymond P., St. Peters, MO Missouri 63376 (US)
(74) Representative: Kenrick, Mark Lloyd

(57) **Abstract**

A heat exchanger includes an inlet header configured to receive refrigerant and an outlet header configured to discharge the refrigerant. First and second tubes in fluid communication with and extending between the inlet header and the outlet header direct refrigerant from the inlet header to the outlet header. Each of the tubes has a first side and a second side. The first side of the first tube is oriented to face the second side of the second tube. A first thermoelectric generator is in thermal communication with the first side of the first tube and a second thermoelectric generator is in thermal communication with the second side of the second tube. A plurality of fins is in thermal contact with the first thermoelectric generator and the second thermoelectric generator and with a surrounding environment.

## Description

### BACKGROUND

The present invention relates to a condenser for condensing a thermal medium, and more particularly, to a microchannel refrigerant condenser with thermoelectric power generation.

The primary components of a typical refrigeration circuit include a compressor, a condenser, an expansion valve, and an evaporator. The condenser receives compressed refrigerant gas from the compressor and liquefies it, rejecting the superheat and latent heat of vaporization to a surrounding environment. This rejected heat represents a source of unrecovered energy.

### SUMMARY

In one construction of the invention a heat exchanger includes an inlet header configured to receive refrigerant and an outlet header configured to discharge the refrigerant. First and second tubes in fluid communication with and extending between the inlet header and the outlet header direct refrigerant from the inlet header to the outlet header. Each of the tubes has a first side and a second side. The first side of the first tube is oriented to face the second side of the second tube. A first thermoelectric generator is in thermal communication with the first side of the first tube and a second thermoelectric generator is in thermal communication with the second side of the second tube. A plurality of fins is in thermal contact with the first thermoelectric generator and the second thermoelectric generator and with a surrounding environment.

In one construction of the invention a heat exchanger includes an inlet header configured to receive refrigerant and an outlet header configured to discharge refrigerant. At least one tube is in fluid communication with and extends between the inlet header and the outlet header, has a first side and an opposing second side, and is configured to pass the refrigerant from the inlet header to the outlet header. A first thermoelectric generator is in thermal communication with the first side of the at least one tube and with a surrounding environment. A second thermoelectric generator is in thermal communication with the second side of the at least one tube and with the surrounding environment.

In one embodiment of a method of operating a refrigerated merchandiser having a refrigeration system, in which the refrigeration system includes a refrigerant condenser receiving compressed refrigerant from a compressor and discharging condensed refrigerant to a refrigerant evaporator, and in which the condenser includes at least one tube for directing refrigerant that defines a surface area for exchanging heat from the refrigerant to the surrounding environment, the method includes operating the refrigeration system and extracting thermal energy from the surface area. The method also includes converting the thermal energy to electrical energy. The method further includes transferring the electrical energy to an electrical device of the refrigerated merchandiser.

Other aspects of the invention will become apparent by consideration of the detailed description and accompanying drawings.

### BRIEF DESCRIPTION OF THE DRAWINGS

Fig. 1 is a schematic of a refrigeration system including a condensing heat exchanger embodying the present invention.
Fig. 2 is a perspective view of the condenser of the system of Fig. 1.
Fig. 3 is a perspective view of another condenser for use in the system of Fig. 1.
Fig. 4 is a plan view of the condenser of Fig. 2.
Fig. 5 is a partial plan view of the condenser of Fig. 2.
Fig. 6 is a partial perspective view of the condenser of Fig. 2.
Fig. 7 is a schematic view of a control system for the refrigeration system.

### DETAILED DESCRIPTION

Before any embodiments of the invention are explained in detail, it is to be understood that the invention is not limited in its application to the details of construction and the arrangement of components set forth in the following description or illustrated in the following drawings. The invention is capable of other embodiments and of being practiced or of being carried out in various ways.

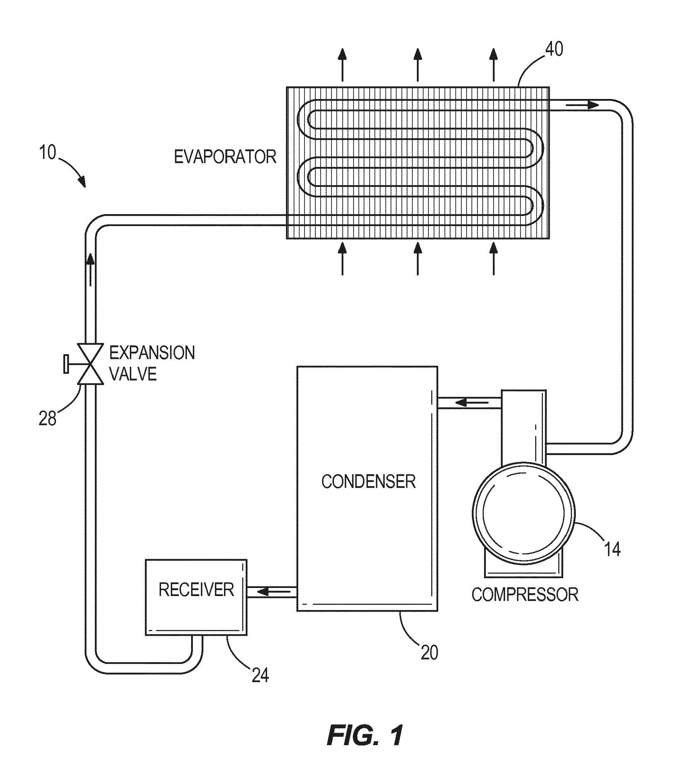

Fig. 1 illustrates a refrigeration circuit 10 for use with a refrigerated merchandiser or other heating, ventilation, air conditioning or refrigeration system (not shown). The refrigeration circuit 10 includes a compressor 14 that discharges gaseous refrigerant to a condenser or heat exchanger 20, which cools the refrigerant via heat exchange with air or another medium (not illustrated) flowing through and around the heat exchanger 20. A receiver 24 receives the condensed refrigerant, which is then directed through an expansion valve 28 to an evaporator 40. The evaporator 40 cools a medium (e.g., an airflow through a refrigerated display case) via heat exchange between refrigerant flowing through the evaporator 40 and the medium. As one of ordinary skill in the art will appreciate, the refrigeration circuit 10 can include other components depending on design parameters and the conditioning needs for which the refrigeration circuit 10 is being used. The heat exchanger 20 to be described herein is not limited in its application to a refrigerated merchandiser, or to a refrigeration circuit, but may be used in any application in which heat is exchanged between a thermal medium and a surrounding environment.

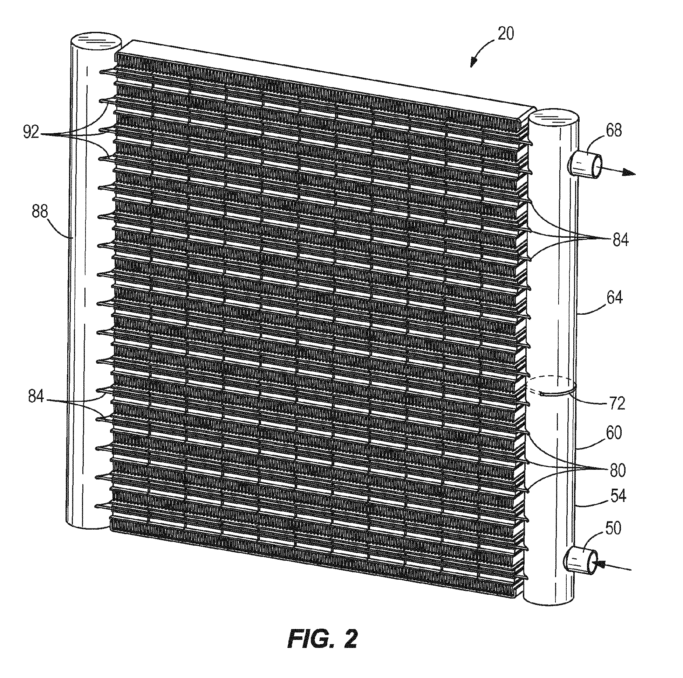

With reference to Figs. 1 and 2, the heat exchanger 20 includes an inlet port 50 that fluidly couples refrigeration system piping (not shown) to a first header 54 to direct gaseous compressed refrigerant from the compressor 14 to the heat exchanger 20. The first header 54 is partitioned into a first section 60 in fluid communication with the inlet port 50, and a second section 64 in fluid communication with an outlet port 68. The sections 60, 64 are fluidly separated from each other by a barrier 72. Compressed refrigerant is directed through the first section 60 and enters a first portion 80 of a plurality of spaced apart tubes 84. As understood by one of ordinary skill in the art, refrigerant is condensed within the tubes 84 by heat exchange with a cooling medium, such as air, flowing through and around the heat exchanger 20. In other applications, the medium can be a liquid (e.g., water). Refrigerant from the tubes 84 collects in a second, or intermediate header 88 at an intermediate point in the cooling/condensing process and is directed to a second portion 92 of the plurality of tubes 84, from which additional heat is exchanged with the surrounding environment. The condensed refrigerant collects in the second section 64 of the first header 54 and is discharged through the outlet port 68, which is fluidly coupled to the evaporator 40 via additional refrigeration system piping (not shown).

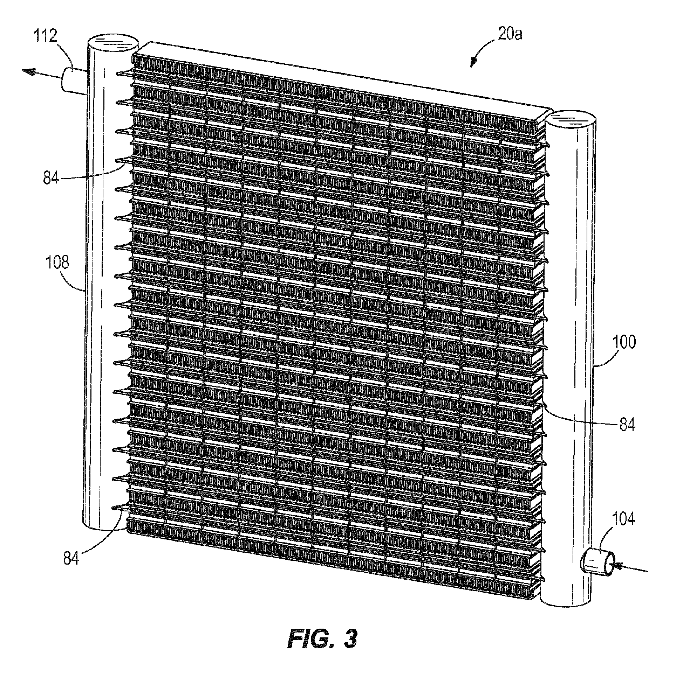

Fig. 3 illustrates another heat exchanger 20a that is similar to the heat exchanger 20 described with regard to Fig. 2. The heat exchanger 20 has an non-partitioned first header 100 through which the compressed refrigerant flows from an inlet port 104 to each of the tubes 84. The refrigerant is condensed within the tubes 84, collects in an outlet header 108, and is thereafter discharged through an outlet port 112 fluidly coupled to the evaporator 40 of the circuit 10.

In other constructions, the heat exchanger 20, 20a can include multiple inlet ports along the first header 54, 100 and multiple outlet ports along the outlet header 108 that are transversely spaced apart from each other to more uniformly distribute refrigerant to and from the tubes 84. The heat exchanger 20 can also include other devices used for uniformly distributing refrigerant, such as a manifold with or without baffles.

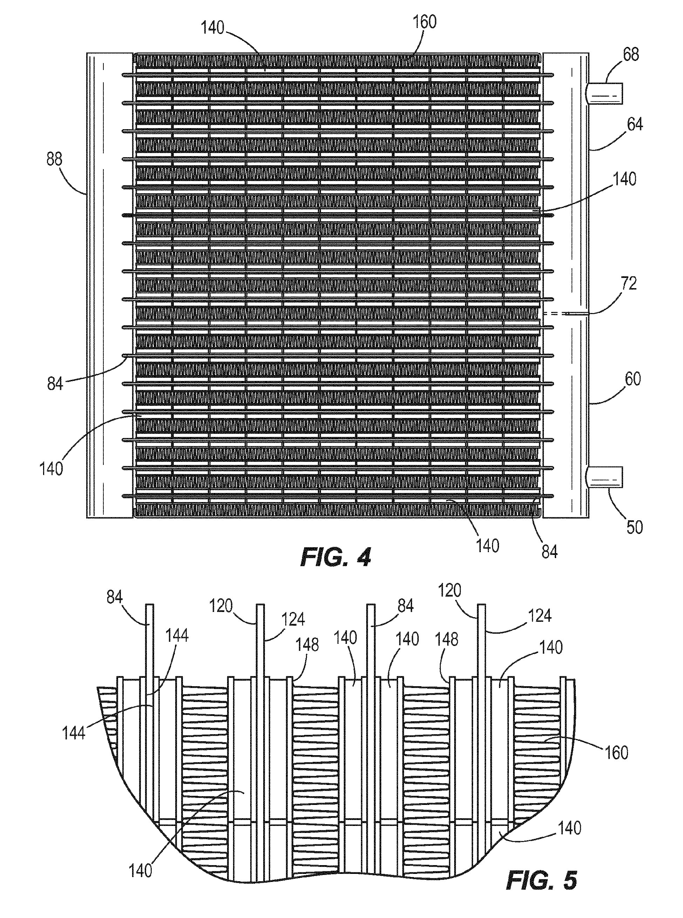

With reference to Figs. 4-6, the illustrated tubes 84 are flat tubes fluidly coupled to and extending between the first header 54, 100 and the second header 88, 108. Each flat tube 84 defines a generally flat or planar first surface 120 and a generally flat or planar second surface 124 opposing the first surface 120. The flat tubes 84 are spaced apart from each other by a predetermined distance, although the spacing between adjacent flat tubes 84 can vary substantially based on the application in which the heat exchanger 20, 20a is used. In addition, the wall thickness of the tubes 84 can vary substantially due to material, operating environment, and working pressure requirements. The flat tubes 84 can be formed from any suitable material and method, for example, extruded aluminum or folded aluminum.

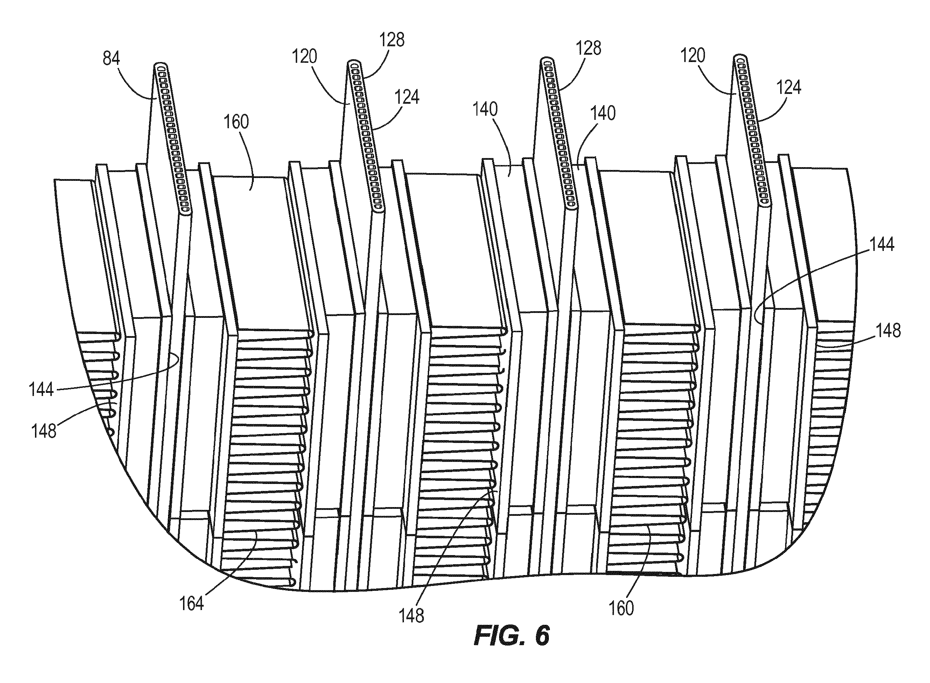

Referring to Fig. 6, in some applications the flat tubes 84 define a plurality of internal passageways or microchannels 128 that are each smaller in size than the internal passageway of a heat exchanger coil in a conventional fin-and-tube heat exchanger. The microchannels 128 are defined by a rectangular cross-section, although other cross-sectional shapes are possible and considered herein. Each illustrated tube 84 has between fifteen to thirty microchannels 128, with each microchannel being about 1 mm in height and about 1 mm in width. In other constructions, the microchannels 128 can vary substantially, for example, from as small as 0.5 mm by 0.5 mm to as large as 4 mm by 4 mm. The size and configuration of the microchannels 128 within the tubes 84 can vary to accommodate the variations in tube construction noted above. The precise length, width, and quantity of microchannels 128 are a function of the amount of thermal fluid, e.g., refrigerant, needed for the particular application to maximize heat transfer while minimizing system pressure drop. The microchannels 128 are fluidly coupled to and extend between the first/inlet and second/outlet headers 54, 100 and 88, 108. In other embodiments, the tubes 84 need not be microchannel tubes and can include a single internal passageway.

With further reference to Figs. 4-6, one or more thermoelectric generators 140 are thermally coupled to at least one of the first surface 120 and the second surface 124 of each tube 84. Each thermoelectric generator 140 includes a first surface 144 configured for thermal communication with a source of heat, and a second surface 148 configured for thermal communication with a heat sink. Thermoelectric generators 140 are solid-state devices consisting of pairs of n-type and p-type semiconductor materials, as will be understood by one of ordinary skill in the art. When the thermoelectric generator 140 is in thermal communication with a heat source and a heat sink, the thermoelectric generator 140 is capable of power generation by virtue of the Seebeck effect, the details of which are known to those of ordinary skill in the art.

Referring to Figs. 4-6, one or more thermoelectric generators are positioned partially or entirely along the first surface 120 and/or the second surface 124 of the tube 84 from the first/inlet header 54, 100 to the second/outlet header 88, 108, depending on the application. Specifically, the first surface 144 of each thermoelectric generator 140 is coupled to the one of the first or second surfaces 120, 124 of a tube 84 such that the first surface 144 is in thermal communication with the tube surface. The second surface 148 of each thermoelectric generator 140 is coupled to a fin arrangement 160 of the heat exchanger 20, 20a. As illustrated in Figs. 2-6, the fin arrangement 160 has a plurality of fins 164 that extend between the second surface(s) 148 of one or more thermoelectric generators 140 coupled to one tube 84 and the second surface(s) 148 of one or more thermoelectric generators 140 coupled to an adjacent tube 84. In other applications, a fin arrangement 160 or plurality of fins 164 is absent, and the second surface 148 of each thermoelectric generator 140 is in thermal communication with the cooling medium without the assistance of fins. In these applications, the tubes 84 are supported by other structure.

The fins 164 generally aid in heat transfer between the cooling fluid passing through the heat exchanger 20 and the thermal fluid (refrigerant) flowing within the tubes 84 by increasing the surface area of thermal contact. As illustrated, the fins 164 are arranged in a zigzag pattern between opposing thermoelectric generators 140. The fin density measured along the length of the tubes 84 can vary depending on the application, and may also include additional surface features and/or shapes to provide additional heat transfer area (e.g., triangular, wavy, perforated, etc.). The thickness of the fins 164 can also vary depending on the desired heat transfer characteristics and other design considerations.

Because thermoelectric power generation is dependent upon the temperature differential between the heat source and the heat sink, the number and arrangement of thermoelectric generators 140 can vary depending on the application (i.e., on the temperature of the heat source and the temperature of the surrounding environment). In some embodiments, for example, only sensible heat is extracted from the thermal fluid, and thermoelectric generators 140 may therefore only extend a portion of the way along the tube surfaces 120, 124 from the first header 54, 100 to the second header 88, 108 as the temperature of the thermal fluid decreases within the tube between the headers. That is, the temperature differential from the heat source to the heat sink within some portion of the heat exchanger 20, 20a may not be preferable for the application of a thermoelectric generator. In other applications in which primarily latent heat is extracted, the temperature of the heat source will stay substantially constant, and thermoelectric generators 140 may be positioned along the full length of the tubes 84.

In operation of the heat exchanger 20, the thermal fluid (e.g., compressed refrigerant from the compressor 14) enters the inlet port 50 of the first section 60 of the first header 54, flows through the first section 60 and enters the microchannels 128 of the first portion 80 of the one or more tubes 84. As the fluid flows within the first portion of tubes 84, the temperature differential between the relatively hot fluid and the cooler surrounding environment creates a temperature gradient. The thermoelectric generators 140 disposed within this temperature gradient (i.e., between the surfaces 120, 124 of the tube 84 and the surrounding environment, with or without the aid of fins 164) generate power from the temperature differential in a process known to those of skill in the art (i.e., based on the Seebeck effect). Partially cooled and/or condensed thermal fluid from the first portion 80 enters the second or intermediate header 88 and is directed to the second portion 92 of the tubes 84. Power is again generated and delivered by the associated thermoelectric generators 140 by virtue of the existing temperature differential between the tubes 84 and the environment. Cooled and/or condensed thermal fluid collects in the second section 64 of the first header 54 and is discharged through the outlet port 68 to the remainder of the system.

During operation of the heat exchanger 20a as illustrated in Fig. 3, thermal fluid (e.g., compressed refrigerant) enters the inlet port 104 of the inlet header 100, flows through the inlet header 100 and enters the microchannels 128 of each tube 84. As the refrigerant passes through the tubes 84 to the outlet header 108, power is generated and delivered by the thermoelectric generators 140 coupled to the tubes 84 in the same manner as described with regard to the heat exchanger 20.

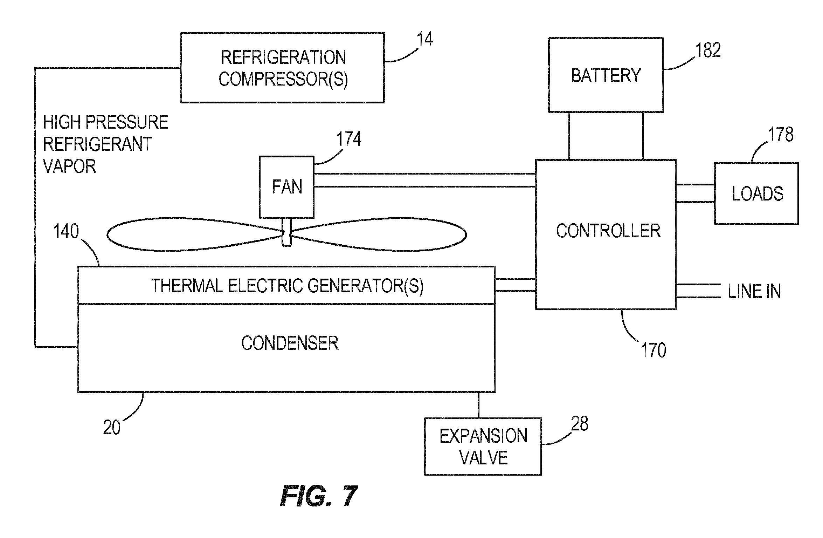

The power generated by the thermoelectric generators 140 is delivered through wiring to components of the system, or elsewhere, depending on the system configuration. For example, as shown in Fig. 7, the generated power can be delivered to a controller 170, which further conditions the voltage and current to appropriate levels for use in other system components. These system components can include, for example, the condenser fan 174 or other loads 178 (e.g., other fans, lights, valves, heaters, etc.) that can be at least partially powered by the power generated by the thermoelectric generators 140. In other embodiments, the power may be sent to a battery or bank of batteries 182 for power storage. In still other embodiments, the power, if within proper limits, may be delivered directly to these system components without conditioning by a controller. Multiple thermoelectric generators 140 can be electrically connected in a parallel or series configuration as necessary to meet system requirements.
Various features and advantages of the invention are set forth in the following claims.

## Claims

1. A heat exchanger comprising:
an inlet header configured to receive refrigerant;
an outlet header configured to discharge the refrigerant;
first and second tubes in fluid communication with and extending between the inlet header and the outlet header to direct refrigerant from the inlet header to the outlet header, each of the tubes having a first side and a second side, the first side of the first tube oriented to face the second side of the second tube;
a first thermoelectric generator in thermal communication with the first side of the first tube;
a second thermoelectric generator in thermal communication with the second side of the second tube; and
a plurality of fins in thermal contact with the first thermoelectric generator and the second thermoelectric generator and with a surrounding environment.

2. The heat exchanger of claim 1, wherein the surrounding environment comprises air.

3. The heat exchanger of claim 2, wherein at least one of the first thermoelectric generator and the second thermoelectric generator is electrically coupled to a fan operable to generate a stream of air across the first and second tubes.

4. The heat exchanger of claim 1, wherein:
the heat exchanger is a condenser within a refrigeration circuit, and wherein at least one of the first thermoelectric generator and the second thermoelectric generator is electrically coupled to a component of the refrigeration circuit; or
at least one of the first thermoelectric generator and the second thermoelectric generator is electrically coupled to a battery; or
the first and second tubes are microchannel tubes.

5. The heat exchanger of claim 1, further including a third thermoelectric generator in thermal communication with the first side of the first tube and with the plurality of fins.

6. A heat exchanger comprising:
an inlet header configured to receive refrigerant;
an outlet header configured to discharge refrigerant;
at least one tube in fluid communication with and extending between the inlet header and the outlet header, the at least one tube having a first side and an opposing second side and configured to pass the refrigerant from the inlet header to the outlet header;
a first thermoelectric generator in thermal communication with the first side of the at least one tube and with a surrounding environment; and
a second thermoelectric generator in thermal communication with the second side of the at least one tube and with the surrounding environment.

7. The heat exchanger of claim 6, wherein the at least one tube is a microchannel tube.

8. The heat exchanger of claim 6, wherein the surrounding environment comprises air.

9. The heat exchanger of claim 8, wherein at least one of the first thermoelectric generator and the second thermoelectric generator is electrically coupled to a fan, and further wherein the fan is at least partially powered by the at least one of the first thermoelectric generator and the second thermoelectric generator,
wherein optionally the fan is operable to generate a stream of air across the at least one tube.

10. The heat exchanger of claim 6, wherein the heat exchanger is a condenser within a refrigeration circuit, and wherein at least one of the first thermoelectric generator and the second thermoelectric generator is electrically coupled to a component of the refrigeration circuit.

11. The heat exchanger of claim 6, further including a third thermoelectric generator in thermal communication with the first side of the at least one tube and with a surrounding environment and optionally further including a fourth thermoelectric generator in thermal communication with the second side of the at least one tube and with a surrounding environment.

12. The heat exchanger of claim 6, wherein:
at least one of the first thermoelectric generator and the second thermoelectric generator is thermally coupled to a plurality of fins, the fins disposed within the surrounding environment; and/or
the first thermoelectric generator and the second thermoelectric generator are electrically connected in a series configuration; and/or
the first thermoelectric generator and the second thermoelectric generator are electrically connected in a parallel configuration.

13. A method of operating a refrigerated merchandiser having a refrigeration system, the refrigeration system including a refrigerant condenser receiving compressed refrigerant from a compressor and discharging condensed refrigerant to a refrigerant evaporator, the condenser including at least one tube for directing refrigerant, the tube defining a surface area for exchanging heat from the refrigerant to the surrounding environment, the method comprising:
operating the refrigeration system;
extracting thermal energy from the surface area;
converting the thermal energy to electrical energy; and
transferring the electrical energy to an electrical device of the refrigerated merchandiser.

14. The method of claim 13, wherein transferring the electrical energy to an electrical device of the refrigerated merchandiser means transferring the electrical energy to an electrically-powered device, and wherein optionally the electrically-powered device is selected from the group consisting of a fan operable to generate a stream of air through the condenser, a heater, a light, and a valve of the refrigeration system.

15. The method of claim 13, wherein transferring the electrical energy to an electrical device of the refrigerated merchandiser means transferring the electrical energy to an electrical storage device.
